# NEUE EUROPÄISCHE PATENTSCHRIFT

(11) **EP 0 695 036 B2**
(45) Veröffentlichungstag und Bekanntmachung des Hinweises auf die Entscheidung über den Einspruch: **16.08.2001**
(45) Hinweis auf die Patenterteilung: 01.04.1998
(21) Anmeldenummer: 95810467.1
(22) Anmeldetag: 14.07.1995
(51) Int. Cl.: H03K 17/95, B23P 11/02

(54) **Näherungsschalter mit keramischer Stirnfläche und Verfahren zu dessen Herstellung**
Proximity switch with ceramic cap and manufacturing method therefor
Commutateur de proximité avec pièce de fermeture céramique et procédé pour la fabrication du même

(30) Priorität: 26.07.1994 CH 235894
(43) Veröffentlichungstag der Anmeldung: 31.01.1996
(73) Patentinhaber: Optosys SA, 1762 Givisiez (CH)
(72) Erfinder: Heimlicher, Peter, CH-1700 Freiburg (CH)
(74) Vertreter: AMMANN PATENTANWAELTE AG BERN

(56) Entgegenhaltungen:
- EP-A- 0 197 890
- DE-A- 3 313 826
- DE-C- 3 545 135
- DE-C- 3 717 932
- DE-C- 3 805 636

## Beschreibung

Näherungsschalter verschiedener Technologien (induktiv, kapazitiv, Ultraschall, magnetisch und andere) sind bestimmungsgemäss starker Beanspruchung durch Umwelteinflüsse ausgesetzt. Der dadurch erforderliche Schutz der in ihnen enthaltenen Baugruppen ist ein wichtiges Anliegen. Deshalb verfügen die marktgängigen Geräte zumeist bereits über Gehäuse aus Metall oder hochwertigen Kunststoffen, deren Inneres in der Regel zudem mit Giessharz vergossen ist.

In der Praxis gibt es allerdings Anwendungsfälle, wo diese Massnahmen nicht susreichen, z.B. beim Vorhandensein aggressiver Chemikalien, hoher Temperaturen und Drücke sowie in der Lebensmittelindustrie. Hier werden bevorzugt Gehäuse aus Edelstahl eingesetzt. Von besonderem Interesse ist dabei die aktive Fläche, da sie in der Regel aus einem elektrisch isolierenden Material bestehen muss. Das Material der Wahl ist hier Keramik.

Das schwierig zu lösende Problem besteht in der gas- und flüssigkeitsdichten Verbindung der keramischen aktiven Fläche mit dem Gehäuse. An diese Verbindung werden hohe Anforderungen gestellt. Sie soll nicht nur dicht, sondern zudem druckfest, vibrationsbeständig und über einen weiten Temperaturbereich verwendbar sein. Im weiteren wird eine sehr gute Beständigkeit gegen Temperaturzyklen gefordert. Hervorragende chemische Beständigkeit ist selbstverständlich. Alle diese Eigenschaften müssen über die Produktelebensdauer, die typischerweise über 10 Jahre beträgt, erhalten bleiben. Zudem soll das Herstellungsverfahren einfach, sicher und vor allem wirtschaftlich sein.

Ein weiteres Problem besteht darin, dass die aktive Fläche möglichst dünn sein soll, denn der Nutzschaltabstand des Sensors reduziert sich naturgemäss um ihre Dicke. Dies ist insbesondere dann von Bedeutung, wenn das Gerät hohem äusserem Druck standhalten soll.

Für diese Problemstellung gibt es eine Anzahl von bekannten Lösungen, die allerdings alle mit wesentlichen Nachteilen behaftet sind. Die sicherste Methode besteht darin, das Keramikteil im Bereich der Verbindungsfläche zu metallisieren und anschliessend dicht in das Gehäuse einzulöten. Das so erzielte Resultat ist sehr gut, allerdings ist die Herstellung kompliziert und damit teuer. Ein weiteres Verfahren besteht in der Verklebung der Teile mit einem geeigneten Kleber. Dies ist zwar wirtschaftlich, aber im Langzeitverhalten, insbesondere bei höheren Temperaturen und in aggressiver Umgebung, unsicher.

DE-A-3 313 826 offenbart einen Näherungsschalter mit einer Keramikscheibe. Die Keramikscheibe weist an ihrem Umtang eine metallische Beschichtung, die es erlaubt, diese Keramikscheibe in ein Oszillatorgehause einzulöten Die Lötstelle zwischen Keramikscheibe und Gehause ist trotz eventueller Haarrisse durch thermische Ausgleichskräfte am Umfang gegen den Innenraum mit dem Oszillator hermetisch dicht.

Die vorliegende Erfindung löst die genannten Probleme auf einfache und wirtschaftliche Weise und schlägt dazu einen Näherungsschalter mit den Merkmalen gemäß Anspruch 1 und ein Verfahren zu dessen Herstellung mit den Merkmalen gemäß Anspruch 5 vor. In den abhängigen Ansprüchen sind besondere Ausführungsarten der Erfindung angegeben. Die Erfindung wird im folgenden anhand eines in der Zeichnung dargestellten Ausführungsbeispiels näher erläutert.
- Fig. 1 und 2: zeigen Seiten- bzw. Stirnanischten der zum Gehäuse zu verbindenden Teile,
- Fig. 3: zeigt die durch Aufschrumpfen verbundenen Teile,
- Fig. 4: zeigt eine Variante mit einer Flächengestaltung zur Erhöhung des Anpressdruckes,
- Fig. 5: zeigt eine Dichtungsbeschichtung und
- Fig. 6: zeigt die Kräfteverhältnisse im eingesetzten Keramikteil.

Ausgangspunkt ist das bereits für andere Zwecke eingesetzte, an sich bekannte Verfahren, ein Metallteil auf ein zugehöriges Innenteil aus Keramik aufzuschrumpfen. Beispiele dazu finden sich in DE-A-40 32 803, DE-A-40 21 259, EP-A-0 197 890 und DE-C-35 45 135. Dazu wird der Durchmesser des Keramikteils 2 leicht grösser als derjenige der entsprechenden Aufnahme 3 im Gehäusemantel 1 gewählt. Zur Einfuhrung des Keramikteils 2 in den Gehäusemantel 1 wird dieser im Bereich der Aufnahme 3 auf eine Temperatur von z. B. 800 °C erhitzt. Die Erwärmung kann dabei in bekannter Art auf einfache und schnelle Art mittels Induktionserwärmung erfolgen. Dadurch dehnt sich der Gehäusemantel 1 aus (der lineare Ausdehnungskoeffizient beträgt z.B. bei V2A ca. 12 x 10⁻⁶ / °C). Das nicht erhitzte und daher nicht ausgedehnte Keramikteil 2 wird jetzt ohne jeden Krafteinsatz in die entsprechende Aufnahme 3 im Gehäusemantel 1 eingelegt. Anschliessend wird die Energiezufuhr unterbrochen, worauf sich das Ganze abkühlt. Infolge der damit erfolgenden Schrumpfung des Gehäuses 1 resultiert ohne weiteres Zutun ein Kraftschluss zwischen Gehäuse 1 und Keramikteil 2.

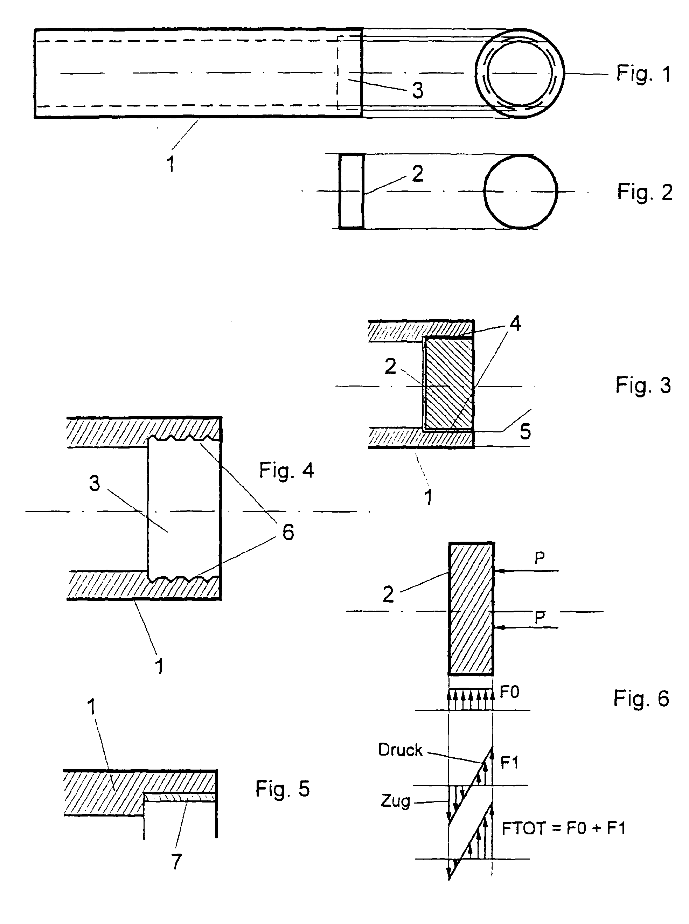

Die derart erzielte Verbindung zeichnet sich zwar durch einen intensiven Kraftschluss aus, ist aber in der Regel nicht gas- und flüssigkeitsdicht. Erfindungsgemäss wird daher die Oberfläche des Metallgehäusemantels 1 vorbehandelt, typischerweise durch Aufbringen einer geeigneten Schicht 7 (Fig. 5) (Dicke einige 10 µm) eines duktilen Metalls, z.B. Kupfer, im Bereich der Verbindungsstelle 4 (Fig. 4). Dadurch ergibt sich bei geeigneter Dimensionierung von Schichtdicke und Flächenpressung eine hervorragende Dichtung. Vorteilhafterweise wird zuerst der ganze Gehäusemantel vorbehandelt und nach Herstellung der Verbindung, soweit gewünscht, der nicht mehr benötigte Teil der Schicht wieder entfernt, wobei sie im Bereich der Verbindung infolge des gas- und flüssigkeitsdichten Abschlusses erhalten bleibt.

Durch geeignete Materialauswahl und Bemessung der Wandstärke 5 des Gehäuses im Aufnahmebereich 3 kann die gewünschte Flächenpressung in einem weiten Bereich eingestellt werden. Zusätzlich kann dieser Bereich durch entsprechende Gestaltung der Auflagefläche 6 noch vergrössert werden. Ein Beispiel zeigt Fig. 3, wonach in die Auflagefläche 6 Ringnuten eingearbeitet sind.

Durch die Druckvorspannung im Keramikteil 2 ergibt sich ein weiterer Vorteil, indem Letzterer dadurch bei gegebener Form einem höheren äusseren Druck P standhalten kann, als dies ohne solche Vorspannung möglich wäre (Fig. 6). Dabei wird von der Tatsache Gebrauch gemacht, dass keramische Materialien wesentlich höheren Druck- als Zugspannungen ausgesetzt werden können. Bei Vorspannung durch den aus der Schrumpfung des Metallgehäusemantels resultierenden Druck wird im Keramikteil 2 die Druckspannung F0 erzeugt (Fig. 6). Äusserer Druck P erzeugt die Druckund Zugspannungen F1. Infolge Überlagerung werden die durch äussern Druck P erzeugten Druck- und Zugspannungen F1 um den Betrag der Druckspannung F0 erhöht (Druckspannungen) bzw. reduziert (Zugspannungen). Die in Summe reduzierten resultierenden Zugspannungen ermöglichen damit eine höhere Belastung des Keramikteils 2 durch äusseren Druck P, als dies ohne die genannte Vorspannung zulässig wäre. Vorteilhafterweise wird die Verbindung so ausgelegt, dass nach erfolgter Abkühlung die Streckgrenze des Gehäusematerials im Bereich der Auflagefläche 4 überschritten wird. Dadurch ergibt sich eine von den Bearbeitungstoleranzen weitgehend unabhängige Druckvorspannung.

## Patentansprüche

1. Näherungsschalter mit einem Gehäusemantel (1) aus Metall, in welchen an der aktiven Stirnseite eine Keramikscheibe (2) als Abschluss eingesetzt ist, wobei ein Dichtungsmaterial (7) eine gas- und flüssigkeitsundurchlässige Abdichtung zwischen Gehäusemantel (1) und der Keramikscheibe (2) bewirkt, wobei
i) die Keramikscheibe (2) in den Gehäusemantel (1) eingeschrumpft ist,
ii) die Keramikscheibe (2) ausschliesslich durch Schrumpfung des Gehäusemantels (1) darin gehalten ist, und
iii) das Dichtungsmaterial (7) auschliesslich durch eine Oberflächenbeschichtung gebildet ist, die alternativ auf die eine oder beide Berührungsflächen zwischen Gehäusemantel (1) und der Keramikscheibe (2) aufgebracht ist.

2. Näherungsschalter nach Anspruch 1, dadurch gekennzeichnet, dass als Dichtungsmaterial (7) ein duktiles Metall, z. B. Kupfer vorgesehen ist.

3. Näherungsschalter nach Anspruch 1 oder 2, dadurch gekennzeichnet, dass das Dichtungsmaterial (7) auf die eine oder beide Berührungsflächen zwischen Gehäusemantel (1) und der Keramikscheibe (2) aufgedampft oder aufgalvanisiert ist.

4. Näherungsschalter nach einem der Ansprüche 1 bis 3, dadurch gekennzeichnet, dass durch geeignete Gestaltung, z. B. Nutung der Auflageflächen (6) des Gehäusemantels (1) oder der Keramikscheibe (2) die Flächenpressung erhöht und gleich-oder ungleichmässig über die Verbindungsstelle (4) verteilt ist.

5. Verfahren zur Herstellung eines Näherungsschalters gemäss Anspruch 1, dadurch gekennzeichnet, dass die dichte Verbindung der Keramikscheibe (2) mit dem Gehäusemantel (1) so erfolgt, dass die Keramikscheibe, das bei Umgebungstemperatur einen grösseren Durchmesser als die entsprechende Aufnahme (3) im Gehäusemantel (1) hat, nach Erwärmung des Gehäusemantels (1) in diesen eingelegt wird und nach dessen Abkühlung ausschliesslich infolge Schrumpfung durch Kraftschluss gefasst wird, wobei im Bereich der Verbindungsstelle (4) eine gas- und flüssigkeitsundurchlässige Abdichtung zwischen diesem und der Keramikscheibe entsteht, welche Abdichtung ausschliesslich durch eine Oberflächenbeschichtung gebildet wird, welche auf die eine oder beide Berührungsflächen zwischen Gehäusemantel (1) und der Keramikscheibe (2) aufgebracht wird.

6. Verfahren nach Anspruch 5, dadurch gekennzeichnet, dass die Oberflächenbeschichtung durch Aufbringen einer weichen, duktilen Metallschicht (7) erfolgt, wobei die Metallschicht galvanisch aufgebracht wird und aus Kupfer bestehen kann.

7. Verfahren nach Anspruch 5 oder 6, dadurch gekennzeichnet, dass die Oberflächenbeschichtung auf der gesamten Oberfläche des Gehäusemantels erfolgt.

8. Verfahren nach Anspruch 7, dadurch gekennzeichnet, dass die Oberflächenbeschichtung nach erfolgter Verbindung ausserhalb der Verbindungsstelle wieder entfernt wird.

9. Verfahren nach einem der Ansprüche 5 bis 8, dadurch gekennzeichnet, dass durch die Erzeugung einer höheren Druckvorspannung (F0) auf der Keramikscheibe (2), als zu dessen Befestigung und Abdichtung erforderlich wäre, dessen Festigkeit gegen äusseren Druck (P) erhöht wird.

10. Verfahren nach Anspruch 9, dadurch gekennzeichnet, dass die Auslegung der Flächenpressung im Bereich der Verbindungsstelle (4) so erfolgt, dass in deren Bereich die Streckgrenze des Materials des Gehäusemantels überschritten wird.

## Claims

1. Proximity switch comprising a metallic housing envelope (1) in the active front side of which a ceramic disk (2) is inserted as a closure, a sealing material (7) providing a seal which is impermeable to gases and liquids between the housing envelope (1) and the ceramic disc (2), wherein
i) the ceramic disk (2) is shrink-fit into the housing envelope (1),
ii) the ceramic disk (2) is held in the housing envelope (1) by shrinkage thereof exclusively, and
iii) the sealing material (7) consists of a coating exclusively, the latter being applied to one or to both of the contact surfaces between the housing envelope (1) and the ceramic disk (2).

2. Proximity switch according to claim 1, characterised in that a ductile material such as copper serves as a sealing material (7).

3. Proximity switch according to claim 1 or 2, characterised in that the sealing material (7) is applied to one or both of the contact surfaces between the housing envelope (1) and the ceramic disk (2) by evaporation or galvanic metallizing.

4. Proximity switch according to any one of claims 1 to 3, characterised in that the surface pressure is increased by a suitable design of the bearing surfaces (6) of the housing envelope (1) or of the ceramic disk (2), e.g. by grooving, and regularly or irregularly distributed over the junction (4).

5. Method for the manufacture of a proximity switch according to claim 1, characterised in that the sealing connection of the ceramic disk (2) to the housing envelope (1) is obtained by inserting the ceramic disk, which at ambient temperature has a greater diameter than the corresponding seat (3) in the housing envelope (1), into the housing envelope after the latter has been heated, the ceramic disk (2) being positively maintained only due to the shrinking of the housing envelope when the latter has cooled off, a gas- and liquid-tight seal between the housing envelope and the ceramic disk being obtained in the area of the junction (4), the latter seal being provided exclusively by a coating applied to one or both contact surfaces between the housing envelope (1) and the ceramic disk (2).

6. Method according to claim 5, characterised in that the surface coating is obtained by applying a soft, ductile metal coat (7), the metal coat being applied by galvanic means and possibly consisting of copper.

7. Method according to claim 5 or 6, characterised in that the surface coating is applied to the entire surface of the housing envelope.

8. Method according to claim 7, characterised in that the surface coating outside the junction is again removed as soon as the connection is completed.

9. Method according to one of claims 5 to 8, characterised in that the resistance of the ceramic disk (2) to external pressure (P) is increased by the creation of a higher pressure prestress (F0) of the latter than would be necessary for its fastening and sealing.

10. Method according to claim 9, characterised in that the surface pressure in the area of the junction (4) is so dimensioned that the limit of elasticity of the housing envelope material is exceeded in that area.

## Revendications

1. Détecteur de proximité, comprenant un boîtier avec enveloppe (1) en métal à la face frontale active de laquelle est inséré un disque en céramique (2) en tant que fermeture, un matériau d'étanchéité (7) assurant un étanchement imperméable aux gaz et aux liquides entre l'enveloppe (1) du boîtier et le disque en céramique (2), et
(i) le disque en céramique (2) étant serré dans l'enveloppe (1) du boîtier par rétrécissage,
(i) le disque en céramique (2) étant fixé dans l'enveloppe du boîtier exclusivement par rétrécissage de ce dernier, et
iii) le matériau d'étanchement (7) étant constitué exclusivement par une couche de revêtement appliquée à l'une ou aux deux surfaces de contact entre l'enveloppe (1) du boîtier et le disque en céramique (2).

2. Détecteur de proximité selon la revendication 1, caractérisé en ce qu'un métal ductile tel que le cuivre est prévu en tant que matériau d'étanchéité (7).

3. Détecteur de proximité selon la revendication 1 ou 2, caractérisé en ce que le matériau d'étanchéité (7) est appliqué sur l'une ou sur les deux surfaces de contact entre l'enveloppe (1) du boîtier et le disque en céramique (2) par vaporisation ou galvanisation.

4. Détecteur de proximité selon l'une quelconque des revendications 1 à 3, caractérisé en ce que la pression superficielle est augmentée par une structuration appropriée, par exemple au moyen de rainures, des surfaces d'appui (6) de l'enveloppe (1) du boîtier ou du disque en céramique (2), et répartie régulièrement ou irrégulièrement sur la connexion (4).

5. Procédé de fabrication d'un détecteur de proximité selon la revendication 1, caractérisé en ce que la connexion étanche du disque en céramique (2) et de l'enveloppe (1) du boîtier est obtenue par le fait que le disque en céramique, dont le diamètre à température ambiante est supérieur à celui du logement (3) correspondant dans l'enveloppe (1) du boîtier, est introduit dans ce dernier lorsque l'enveloppe (1) du boîtier est chauffée et est retenue exclusivement par adhésion après refroidissement de celle-ci dû à son retrait, de telle manière qu'un étanchement imperméable aux gaz et aux liquides entre l'enveloppe du boîtier et le disque en céramique est assuré dans la zone de la connexion (4) exclusivement par une couche de revêtement appliquée à l'une ou aux deux surfaces de contact entre l'enveloppe (1) du boîtier et le disque en céramique.

6. Procédé selon la revendication 5, caractérisé en ce que le revêtement de la surface est obtenu par application d'une couche de métal (7) tendre et ductile, ladite couche de métal étant appliquée par galvanisation et pouvant consister de cuivre.

7. Procédé selon la revendication 5 ou 6, caractérisé en ce que le revêtement de surface est appliqué à la surface entière de l'enveloppe du boîtier.

8. Procédé selon la revendication 7, caractérisé en ce que le revêtement de surface est enlevé dès que la connexion est établie sauf à l'endroit de la connexion.

9. Procédé selon l'une des revendications 5 à 8, caractérisé en ce que la résistance du disque en céramique (2) contre la pression extérieure (P) est augmentée par la production d'une précontrainte de pression (F0) sur ledit disque qui est plus élevée que nécessaire pour sa fixation et son étanchement.

10. Procédé selon la revendication 9, caractérisé en ce que la pression superficielle dans la zone de la connexion (4) est calculée de telle manière que la limite d'élasticité du matériau de l'enveloppe du boîtier est dépassée dans cette zone.
